# FASCICULE DE BREVET EUROPEEN

(11) **EP 2 652 627 B1**
(45) Date de publication et mention de la délivrance du brevet: **13.09.2017**
(21) Numéro de dépôt: 11794181.5
(22) Date de dépôt: 13.12.2011
(51) Int. Cl.: G06F 13/40, H03K 5/00

(54) **INTERFACE D'ENTRÉE POUR UN POSTE D'ÉMISSION/RÉCEPTION ET POSTE LE COMPORTANT**
EINGANGSSCHNITTSTELLE FÜR EINE SENDE-EMPFANGSSTATION UND STATION DAMIT
INPUT INTERFACE FOR A TRANSMIT/RECEIVE STATION AND STATION COMPRISING SAME

(30) Priorité: 13.12.2010 FR 1004845
(43) Date de publication de la demande: 23.10.2013
(73) Titulaire: THALES, 92200 Neuilly-sur-Seine (FR)
(72) Inventeur: GEAIRON, Sébastien, F-49309 Cholet Cedex (FR); TRECUL, Franck, F-49309 Cholet Cedex (FR); SAINT-ELLIER, Pierre, F-49309 Cholet Cedex (FR)
(74) Mandataire: Lavoix
(86) Numéro de dépôt international: PCT/EP2011/072547
(87) Numéro de publication internationale: WO 2012/080212

(56) Documents cités:
- US-A- 6 073 201
- US-A1- 2003 225 317

## Description

La présente invention concerne une interface d'entrée pour un poste de radio d'émission/réception comportant :
- une entrée de réception d'un signal soit d'une tension variable sur une plage de tension prédéterminée, soit d'un signal en collecteur ouvert ayant une tension correspondant à l'état logique bas ;
- une première sortie pour le signal de tension variable ;
- une seconde sortie en collecteur ouvert.

Les postes haute fréquence tactiques d'émission/réception sont utilisés notamment lors des opérations militaires pour assurer les communications entre les différentes forces engagées sur le terrain. Ces postes assurent la transmission cryptée de messages audio ou de données. Ils nécessitent plusieurs connecteurs disposés sur leur face avant afin d'assurer la connexion d'équipements auxiliaires et notamment la connexion de moyens d'injection de clés de cryptage afin de permettre le cryptage/décryptage par le poste des messages reçus ou émis.

Suivant les technologies et les normes utilisées pour l'injection des clés de cryptage, les moyens d'injection d'une clé fournissent au poste tactique des signaux de caractéristiques de tension différentes et nécessitent dans le poste des interfaces d'entrées adaptées aux impédances de sortie des moyens d'injection.

Ainsi, les postes tactiques connus actuellement ne permettent l'utilisation que de certains types d'injecteur, ou nécessitent la présence sur leur face avant de plusieurs types de connecteurs, chacun adapté à un type particulier d'injecteur de code.

Le problème de ces postes tactiques est soit qu'ils ne permettent pas l'usage de certains injecteurs de clé, soit qu'ils sont complexes du fait de la multiplication des connecteurs d'entrée.

US 2003/225317 divulgue une interface d'entrée adéquate pour un poste de radio d'émission/réception comportant :
- une entrée de réception d'un signal soit d'une tension variable sur une plage de tension prédéterminée, soit d'un signal en collecteur ouvert ayant une tension 0V correspondant à l'état logique bas ;
- une sortie pour le signal de tension variable et pour le signal en collecteur ouvert avec niveaux de tension modifiés.

L'interface décrite dans ce document ne permet pas de délivrer le signal de tension variable et le signal en collecteur ouvert à un poste de radio à deux entrées séparées.

L'invention a pour but de proposer un poste d'émission/réception haute fréquence permettant l'usage de plusieurs dispositifs auxiliaires fournissant des signaux de caractéristiques différentes et nécessitant des impédances d'entrée différentes, sans multiplier le nombre de connecteurs spécifiques.

A cet effet, l'invention a pour objet une interface d'entrée d'un poste de radio d'émission/réception du type précité, caractérisée en ce que les première et seconde sorties sont reliées à la même entrée et en ce que l'entrée est reliée à un potentiel de référence par un premier pont diviseur de tension dont le point milieu est relié à la borne positive d'un comparateur en boucle ouverte, dont la sortie est reliée à la seconde sortie.

Suivant des modes particuliers de réalisation, l'interface comporte l'une ou plusieurs des caractéristiques suivantes :
- le premier pont diviseur est monté en série avec une diode empêchant la circulation du courant dans le pont diviseur si la tension à l'entrée est supérieure à la tension de référence ;
- les valeurs des résistances du pont diviseur de tension sont telles que pour toute valeur de tension du signal appliqué sur l'entrée dans la plage de tension prédéterminée, la tension sur l'entrée positive du comparateur est positive ;
- une diode de protection est interposée entre l'entrée positive du comparateur et la masse ;
- l'entrée négative du comparateur est connectée à une tension dont la valeur est comprise entre la tension d'alimentation du comparateur et la tension correspondant à l'état logique haut imposée sur l'entrée ;
- l'entrée inverseuse du comparateur est connectée au point milieu d'un pont diviseur de tension connecté à un potentiel de référence ;
- le comparateur comporte un comparateur en collecteur ouvert dépourvu de boucle de contre-réaction ;
- la seconde sortie est reliée à un potentiel de référence au travers d'une résistance de tirage.

L'invention a également pour objet un poste de radio comportant un module d'émission/réception, un circuit de traitement comportant deux entrées et une interface d'entrée selon l'invention, et dont les première et seconde sorties sont reliées aux deux entrées.

L'invention sera mieux comprise à la lecture de la description qui va suivre, donnée uniquement à titre d'exemple et faite en se référant aux dessins sur lesquels :
- la figure 1 est une vue schématique d'un poste tactique selon l'invention ; et
- la figure 2 est une vue du schéma électrique de l'interface d'entrée du poste tactique de la figure 1.

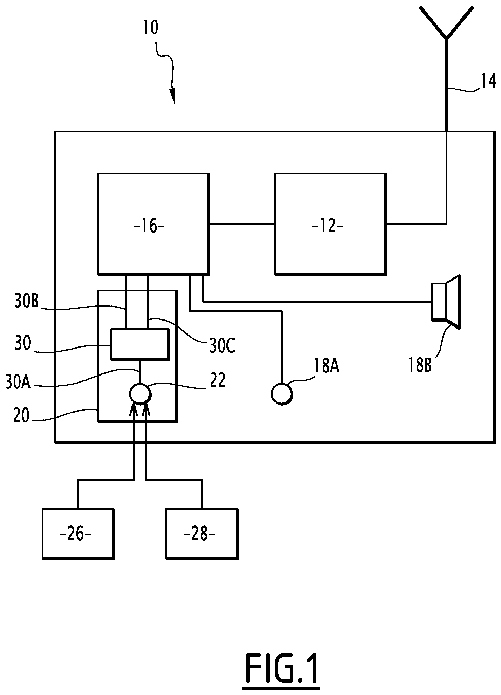

Le poste tactique 10 représenté sur la figure 1 est propre à assurer des émissions/réceptions, notamment cryptées, vers et depuis d'autres postes tactiques.

A cet effet, et comme convenu en soi, il comporte un module 12 d'émission/réception, relié à une antenne 14. Il comporte en entrée du module d'émission/réception 12, un module du cryptage 16 connecté à une entrée 18A d'informations à émettre sur laquelle peut être connecté un microphone ou tout moyen de stockage de données tel qu'un disque dur.

En outre, le poste 10 comporte une interface d'entrée 20 pour recevoir des clés de cryptage depuis un injecteur de clé amovible. Cette interface est reliée au module de cryptage 16.

L'interface 20 comporte un connecteur 22, notamment à 14 broches. Ce connecteur est propre à recevoir un premier injecteur de clés de cryptage 26 propre à introduire dans le poste tactique un signal représentatif de la clé de cryptage. L'injecteur 26 est propre à être connecté en collecteur ouvert.

Le même connecteur 22 est propre à être connecté à un injecteur de clés de cryptage différent 28 assurant la transmission, sur la même broche du connecteur que l'injecteur 26 d'un signal à la norme V28 (RS232).

L'interface 20 comporte, disposée entre le connecteur 22 et le module de cryptage 16, un module de démultiplexage 30 propre à recevoir, sur une entrée 30A un signal issu d'une borne du connecteur 22 à laquelle est connectée l'injecteur de code 26 ou 28 et à produire suivant le type de signal reçu sur l'une ou l'autre de deux sorties 30B, 30C reliées au module de codage 16, une clé de cryptage soit à la norme V28, soit suivant un montage en collecteur ouvert.

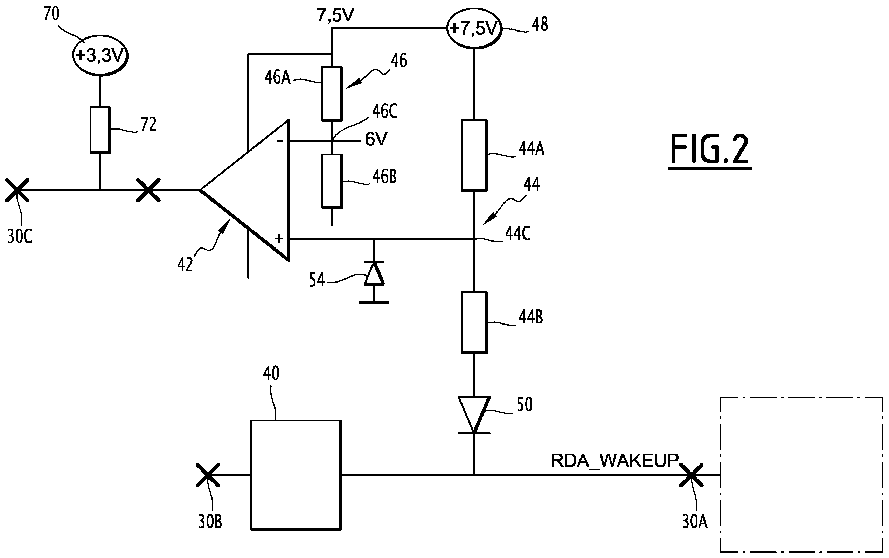

Le schéma du circuit de démultiplexage 30 est illustré sur la figure 2 sur lequel on retrouve l'entrée 30A constituant l'une des broches du connecteur 22 et les deux sorties 30B et 30C pour respectivement un signal à la norme V28 et un signal dit en collecteur ouvert.

L'entrée 30A est reliée par un circuit d'attaque 40 à la norme RS232 directement à la sortie 30B. Ce circuit connu en soi est propre au traitement et à l'interprétation des clés de cryptage reçues.

Par ailleurs, l'entrée 30A est reliée à la sortie 30C par l'intermédiaire d'un circuit comparateur 42 en boucle ouverte et en collecteur ouvert relié par son entrée positive au point milieu d'un pont diviseur de tension 44, son entrée négative étant elle-même reliée depuis le point milieu d'un autre pont diviseur de tension 46.

Le pont diviseur 44 est formé de deux résistances 44A et 44B reliées en série depuis une source de tension 48 propre à imposer un potentiel positif, par exemple égal à 7,5V. La résistance 44B est reliée à l'entrée 30A du circuit par une diode 50 de protection dont la cathode est reliée à l'entrée 30A pour ne permettre la circulation d'un courant dans le pont diviseur 44 que lorsque la tension à l'entrée 30A est inférieure à la tension fournie par la source de tension 48. Cette diode est une protection du comparateur pour les tensions en 30A supérieures à la tension de la source de tension assurant l'alimentation 48.

Le point milieu noté 44C du pont diviseur de tension 44 est relié à l'entrée positive ou non-inverseuse du circuit comparateur 42. Une diode de protection 54 relie cette même entrée non-inverseuse à la masse, la diode étant orientée avec sa cathode connectée à l'entrée non-inverseuse.

Les valeurs des résistances 44A et 44B sont calculées de sorte que la tension appliquée à la borne positive soit nulle et à tout le moins supérieure à -0,4V lorsque la tension à l'entrée 30A est égale à la tension minimale pouvant être appliquée à l'entrée 30A compte tenu des contraintes de la norme V28, c'est-à-dire -25V. Par exemple, pour une tension de la source 48 égale à 7,5V, la résistance 44A a une valeur de 3kΩ et la résistance 44B de 10kΩ.

Dans ce cas, pour une tension nulle à l'entrée 30A, la tension sur l'entrée positive ou non-inverseuse est de 5,5V.

L'entrée négative ou inverseuse du circuit comparateur 42 est connectée au point milieu noté 46C du pont diviseur de tension 46, lequel est formé de deux résistances en série 46A et 46B dont l'une des résistances est reliée à la source de tension 48. Le circuit comparateur 42 est alimenté par la source de tension 48.

Le circuit comparateur 42 est par exemple un composant de référence LM397 pour lequel la tension sur les entrées négatives et positives doit être maintenue entre - 0,4V et 7,5V, sous peine de destruction.

Les valeurs des résistances 46A et 46B sont choisies de sorte que la tension à l'entrée non-inverseuse soit inférieure à la tension d'alimentation de l'amplificateur opérationnel et supérieure à la tension présente à la borne non-inverseuse, telle que fixée par le pont diviseur 44 lorsque la tension à l'entrée 30A est fixée à 0V par l'injecteur de clés qui y est connecté.

Par exemple, la valeur de la résistance 46A est de 2,5kΩ alors que la valeur de la résistance 46B est de 10kΩ. Dans ce cas, la tension à l'entrée inverseuse est de 6V.

La sortie du circuit comparateur 42 est reliée à une source de tension auxiliaire 70, par exemple de 3,3V, par une résistance de tirage 72, propre à imposer une tension sur la sortie 30C en fonction des niveaux de tensions supportés par les composants branchés sur la sortie 30C.

Lorsqu'un injecteur de clés 26 à collecteur ouvert est connecté à l'entrée 30A, celui-ci fournit soit une tension de 0V correspondant à l'état logique bas, soit une tension flottante différente de 0V imposée par l'interface 30 à laquelle il est connecté.

Quand l'injecteur de clés 26 fournit une tension de 0V, le pont diviseur 44, alimenté sous une tension de 7,5V par le générateur 48 établit une tension de 5,5V sur l'entrée positive du comparateur 42. Cette tension étant inférieure à la tension de 6V appliquée sur la borne inverseuse du comparateur par le pont diviseur 46, le comparateur 42 produit en sortie une tension nulle reproduisant ainsi le signal en entrée.

Au contraire, quand l'injecteur de clés 26 fournit une tension non nulle, la tension à l'entrée 30A s'établit à 7,5V, cette tension étant imposée par la seule source 48. Une tension de 7,5V est également appliquée à l'entrée positive du comparateur 42. Cette tension étant supérieure à la tension de 6V imposée à l'entrée négative, la tension sur la sortie 30C s'établit à 3,3V, cette tension étant fixée par le générateur de tension 70 du fait du comparateur 42 à sortie en collecteur ouvert.

Alternativement, lorsque l'injecteur de clés est un injecteur 28 au format V28, le signal reçu en entrée a une tension comprise soit entre +3V et +25V, soit entre -3V et -25V.

Ce signal est délivré directement au circuit d'attaque 40 qui assure son traitement.

Lorsque la tension est de -25V, la tension appliquée sur la borne positive du comparateur 42 est nulle par construction du pont diviseur de tension 44. Toutefois, la diode 54 assure une circulation du courant au cas où une tension négative serait appliquée sur l'entrée positive du comparateur 42, assurant en cela une protection du comparateur 42.

Pour les tensions comprises entre -25V et 7,5V, la tension appliquée sur la borne non-inverseuse varie de 0 à 7,5V, cette tension étant compatible avec les contraintes techniques imposées par le comparateur 42.

Pour les tensions comprises entre +7,5V et +25V, la diode 50 assure un blocage de la tension interdisant la circulation de tout courant dans le pont diviseur de tension 40 de sorte que la tension appliquée sur la borne non-inverseuse est de +7,5V, ce qui est compatible avec les contraintes d'exploitation du comparateur 42.

Ainsi, à aucun moment l'entrée du comparateur n'est soumise à une tension inférieure à -0,4V ni supérieure à 7,5V, permettant ainsi son fonctionnement sans risque de destruction.

La solution proposée permet par l'usage de cette interface la mise en oeuvre d'un unique connecteur permettant de connecter sur une unique entrée, soit un injecteur de clés sortant en collecteur ouvert, soit un injecteur de clés conforme à la norme V28, sans destruction d'une partie de l'interface, même lorsque des tensions de valeurs élevées sont appliquées par l'injecteur à la norme V28.

La solution proposée nécessite seulement des composants simples et en faible quantité et peut donc être mise en place dans un encombrement réduit.

## Revendications

1. Interface d'entrée pour un poste de radio d'émission/réception comportant :
- une entrée (30A) de réception d'un signal soit d'une tension variable sur une plage de tension prédéterminée, soit d'un signal en collecteur ouvert ayant une tension correspondant à l'état logique bas ;
- une première sortie (30B) pour le signal de tension variable ;
- une seconde sortie (30C) en collecteur ouvert ;
**caractérisée en ce que** les première et seconde sorties (30C, 30B) sont reliées à la même entrée (30A) et **en ce que** l'entrée (30A) est reliée à un potentiel de référence par un premier pont diviseur de tension (44) dont le point milieu (44C) est relié à la borne positive d'un comparateur (42) en boucle ouverte, dont la sortie est reliée à la seconde sortie (30C).

2. Interface selon la revendication 1, **caractérisée en ce que** le premier pont diviseur (44) est monté en série avec une diode (50) empêchant la circulation du courant dans le pont diviseur (44) si la tension à l'entrée (30A) est supérieure à la tension de référence.

3. Interface (20) selon la revendication 1 ou 2, **caractérisée en ce que** les valeurs des résistances du pont diviseur de tension (44) sont telles que pour toute valeur de tension du signal appliqué sur l'entrée (30A) dans la plage de tension prédéterminée, la tension sur l'entrée positive du comparateur (42) est positive.

4. Interface selon l'une quelconque des revendications précédentes, **caractérisée en ce qu'**une diode (54) de protection est interposée entre l'entrée positive du comparateur (42) et la masse.

5. Interface selon l'une quelconque des revendications précédentes, **caractérisée en ce que** l'entrée négative du comparateur (42) est connectée à une tension dont la valeur est comprise entre la tension d'alimentation du comparateur et la tension correspondant à l'état logique haut imposée sur l'entrée (30A).

6. Interface (20) selon la revendication 5, **caractérisée en ce que** l'entrée inverseuse du comparateur (42) est connectée au point milieu d'un pont diviseur de tension (46) connecté à un potentiel de référence.

7. Interface (20) selon l'une quelconque des revendications précédentes, **caractérisée en ce que** le comparateur (42) comporte un comparateur en collecteur ouvert dépourvu de boucle de contre-réaction.

8. Interface (20) selon l'une quelconque des revendications précédentes, **caractérisée en ce que** la seconde sortie (30C) est reliée à un potentiel de référence au travers d'une résistance de tirage (72).

9. Poste de radio comportant un module d'émission/réception (12), un circuit de traitement (16) comportant deux entrées et une interface d'entrée selon l'une quelconque des revendications précédentes, et dont les première et seconde sorties (30B, 30C) sont reliées aux deux entrées.

## Patentansprüche

1. Eingangsschnittstelle für eine Funk-Sende-/Empfangsstation aufweisend:
- einen Eingang (30A) zum Empfangen entweder eines Signals mit variabler Spannung in einem vorgegebenen Spannungsbereich oder eines Offener-Kollektor-Signals mit einer Spannung, die einem niedrigem logischen Zustand entspricht;
- einen ersten Ausgang (30B)für das Signal mit variabler Spannung;
- einen zweiten Offener-Kollektor-Ausgang (30C);
dadurch charakterisiert, dass der erste und der zweite Ausgang (30C, 30B) mit demselben Eingang (30A) verbunden sind und dadurch, dass der Eingang (30A) mittels einer ersten Spannungsteilerbrücke (44) mit einem Referenzpotential verbunden ist, deren Mittelknoten (44C) mit einem positiven Anschluss (42) eines Offene-Schleife-Vergleichers verbunden ist, dessen Ausgang mit dem zweiten Ausgang (30C) verbunden ist.

2. Schnittstelle gemäß Anspruch 1, dadurch charakterisiert, dass die erste Teilerbrücke (44) in Serie mit einer Diode (50) montiert ist, die die Zirkulation in der Teilerbrücke (44) verhindert, wenn die Spannung am Eingang (30A) größer ist als die Referenzspannung.

3. Schnittstelle (20) gemäß Anspruch 1 oder 2, dadurch charakterisiert, dass die Widerstandswerte der Spannungsteilerbrücke (44) derart sind, dass für jeden Wert des an den Eingang (30A) angelegten Signals im vorgegebenen Spannungsbereich die Spannung am positiven Eingang des Vergleichers (42) positiv ist.

4. Schnittstelle gemäß einem der vorhergehenden Ansprüche, dadurch charakterisiert, dass eine Schutzdiode (54) zwischen dem positiven Eingang des Vergleichers (42) und der Masse geschaltet ist.

5. Schnittstelle gemäß einem der vorhergehenden Ansprüche, dadurch charakterisiert, dass der negative Eingang des Vergleichers (42) mit einer Spannung verbunden ist, deren Wert zwischen der Versorgungsspannung des Vergleichers und der Spannung, die einem hohen logischen Zustand entspricht und die am Eingang (30A) angelegt wird, liegt.

6. Schnittstelle (20) gemäß Anspruch 5, dadurch charakterisiert, dass der invertierende Eingang (42) mit dem Mittelknoten einer Spannungsteilerbrücke (46) verbunden ist, die mit einem Referenzpotential verbunden ist.

7. Schnittstelle (20) gemäß einem der vorhergehenden Ansprüche, dadurch charakterisiert, dass der Vergleicher (42) einen Offener-Kollektor-Vergleicher ohne Rückkopplungsschleife aufweist.

8. Schnittstelle (20) gemäß einem der vorhergehenden Ansprüche, dadurch charakterisiert, dass der zweite Ausgang (30C) über einen Pull-Up-Widerstand (72) mit einem Referenzpotential verbunden ist.

9. Funkstation aufweisend ein Sende-/Empfangsmodul (12), eine Verarbeitungsschaltung (16) aufweisend zwei Eingänge und eine Eingangsschnittstelle gemäß einem der vorhergehenden Ansprüche, deren erster und zweiter Ausgang (30B, 30C) mit den beiden Eingängen verbunden sind.

## Claims

1. An input interface for a transmit/receive radio station including:
- an input (30A) for receiving a signal either with a variable voltage over a predetermined voltage range, or an open connector signal having a voltage corresponding to the low logic state;
- a first output (30B) for the variable voltage signal;
- a second open collector circuit (30C);
**characterized in that** the first and second outputs (30C, 30B) are connected to the same input (30A) and **in that** the input (30A) is connected to a reference potential through a first voltage divider bridge (44), the middle point (44C) of which is connected to the positive terminal of an open loop comparator (42), the output of which is connected to the second output (30C).

2. The interface according to claim 1, **characterized in that** the first divider bridge (44) is mounted in series with a diode (50) preventing the flow of the current in the divider bridge (44) if the input voltage (30A) is greater than the reference voltage.

3. The interface (20) according to claim 1 or 2, **characterized in that** the values of the resistors of the voltage divider bridge (44) are such that for any voltage value of the signal applied on the input (30A) in the pre-determined voltage range, the voltage on the positive input of the comparator (42) is positive.

4. The interface according to any of the preceding claims, **characterized in that** a protective diode (54) is interposed between the positive input of the comparator (42) and the ground.

5. The interface according to any of the preceding claims, **characterized in that** the negative input of the comparator (42) is connected to a voltage, the value of which is comprised between the power supply voltage of the comparator and the voltage corresponding to the high logic state imposed on the input (30A).

6. The interface (20) according to claim 5, **characterized in that** the inverting input of the comparator (42) is connected for the middle point of a voltage divider bridge (46) connected to a reference potential.

7. The interface (20) according to any other preceding claims, **characterized in that** the comparator (42) includes an open collector comparator without any feedback loop.

8. The interface (20) according to any of the preceding claims, characterizing that the second output (30C) is connected to a reference potential through a pull-up resistor (72).

9. A radio station including a transmit/receive module (12) a processing circuit (16) including two inputs and an input interface according to any of the preceding claims, and for which the first and second outputs (30B, 30C) are connected to both inputs.
